# EUROPÄISCHE PATENTANMELDUNG

(11) **EP 4 647 793 A1**
(43) Veröffentlichungstag der Anmeldung: **12.11.2025**
(21) Anmeldenummer: 24174285.7
(22) Anmeldetag: 06.05.2024
(51) Int. Cl.: G01R 33/28, G01R 33/58, G01R 33/30

(54) **MAGNETRESONANZVORRICHTUNG MIT EINER LASERMARKIEREINHEIT**

(71) Anmelder: Siemens Healthineers AG, 91301 Forchheim (DE)
(72) Erfinder: Kimmlingen, Ralph, 90513 Zirndorf (DE)
(74) Vertreter: Siemens Healthineers Patent Attorneys

(57) **Zusammenfassung**

Die Erfindung geht aus von einer Magnetresonanzvorrichtung mit einer Scannereinheit, einen von der Scannereinheit zumindest teilweise umgebenen Patientenaufnahmebereich, einer Patientenlagerungsvorrichtung, die einen bewegbaren Patiententisch, der zu einem Einfahren in den Patientenaufnahmebereich ausgebildet ist, aufweist, und einer Positionsbestimmungseinheit, die zu einer Bestimmung einer Position des Patiententischs bezüglich der Scannereinheit ausgebildet ist und die eine Lasermarkiereinheit umfasst, wobei die Positionsbestimmungseinheit eine Kalibriereinheit zu einer Kalibrierung der Lasermarkiereinheit umfasst.

## Beschreibung

Die vorliegende Erfindung betrifft eine Magnetresonanzvorrichtung mit einer Scannereinheit, einen von der Scannereinheit zumindest teilweise umgebenen Patientenaufnahmebereich, einer Patientenlagerungsvorrichtung, die einen bewegbaren Patiententisch, der zu einem Einfahren in den Patientenaufnahmebereich ausgebildet ist, aufweist, und einer Positionsbestimmungseinheit, die zu einer Bestimmung einer Position des Patiententischs bezüglich der Scannereinheit ausgebildet ist und die eine Lasermarkiereinheit umfasst.

Unabhängig vom grammatikalischen Geschlecht eines bestimmten Begriffes sind Personen mit männlicher, weiblicher oder anderer Geschlechteridentität mit umfasst.

Für eine Magnetresonanzuntersuchung wird zunächst ein Patient auf einem Patiententisch einer Patientenlagerungsvorrichtung positioniert und anschließend der Patiententisch zusammen mit dem Patienten in den Patientenaufnahmebereich eingefahren, bis der Patient, insbesondere ein zu untersuchender Bereich des Patienten, im Isozentrum der Magnetresonanzvorrichtung positioniert ist. Zur korrekten Positionierung des Patienten, insbesondere des zu untersuchenden Bereichs des Patienten, innerhalb des Isozentrums, weist die Magnetresonanzvorrichtung eine Lasermarkiereinheit auf. Mittels der Lasermarkiereinheit wird zunächst auf den zu untersuchenden Bereich des Patienten und/oder auf einer um den zu untersuchenden Bereich des Patienten positionierten lokalen Hochfrequenzspule ein Laserkreuz projiziert. Ein Abstand der Laserprojektion zum Isozentrum ist dabei der Magnetresonanzvorrichtung bekannt, so dass anschließend der Patient, insbesondere der zu untersuchende Bereich des Patienten, im Isozentrum positioniert werden kann.

Eine derartige Lasermarkiereinheit ist im Bereich einer Eingangsöffnung an der Scannereinheit angeordnet. Dabei ist die Lasermarkiereinheit an einem Gehäuseelement, das um die Eingangsöffnung angeordnet ist, beispielsweise in einem trichterförmigen Gehäuseelement und/oder Einsatztrichter, über der Eingangsöffnung angeordnet. Bevorzugt weist hierzu das Gehäuseelement einen nach unten offenen Aufnahmebereich zur Aufnahme der Lasermarkiereinheit auf.

Die Position der Lasermarkiereinheit wird bei Kalibrierungsmessungen sehr genau bestimmt, um beispielsweise ein Messphantom mit hoher Genauigkeit in der magnetische Mitte der Scannereinheit, insbesondere eines Grundmagneten der Scannereinheit, zu positionieren. Dabei basieren viele Messschritte bei einer Qualitätssicherung von einzelnen Komponenten auf einer sehr genauen Einstellung der Lasermarkiereinheit und führen zu potenziell fehlerhafte Ergebnisse, wenn die Position der Lasermarkiereinheit sich mit der Zeit verstellt und/oder ändert. Beispielsweise kann eine Fehlpositionierung der Lasermarkiereinheit bei regelmäßigen Messungen zur Qualitätssicherung von lokalen Hochfrequenzspulen zu Problemen führen. Da eine Änderung der Position der Lasermarkiereinheit als Fehlerquelle nicht unmittelbar für eine medizinisches Bedienpersonal erkennbar ist, schließt sich meist eine aufwendige und langwierige Fehlersuche an, die sogar zu einem teuren Spulenaustausch führen kann.

Für eine Korrektur einer Position der Lasermarkiereinheit ist ein Serviceeinsatz erforderlich, bei der ein Servicetechniker vor Ort eine manuelle Korrektur der Position der Lasermarkiereinheit an der Scannereinheit vornehmen muss. Eine derartige Korrektur ist jedoch sehr zeitaufwendig und teuer.

Der vorliegenden Erfindung liegt insbesondere die Aufgabe zugrunde, eine einfache Erkennung und/oder Korrektur von Positionsfehlern der Lasermarkiereinheit für einen Benutzer zu ermöglichen. Die Aufgabe wird durch die Merkmale den unabhängigen Anspruch gelöst. Vorteilhafte Ausgestaltungen sind in den Unteransprüchen beschrieben.

Die Erfindung geht aus von einer Magnetresonanzvorrichtung mit einer Scannereinheit, einen von der Scannereinheit zumindest teilweise umgebenen Patientenaufnahmebereich, einer Patientenlagerungsvorrichtung, die einen bewegbaren Patiententisch, der zu einem Einfahren in den Patientenaufnahmebereich ausgebildet ist, aufweist, und einer Positionsbestimmungseinheit, die zu einer Bestimmung einer Position des Patiententischs bezüglich der Scannereinheit ausgebildet ist und die eine Lasermarkiereinheit umfasst. Erfindungsgemäß umfasst die Positionsbestimmungseinheit eine Kalibriereinheit zu einer Kalibrierung der Lasermarkiereinheit.

Die Magnetresonanzvorrichtung umfasst bevorzugt eine medizinische und/oder diagnostische Magnetresonanzvorrichtung, die zu einem Erfassen von medizinischen und/oder diagnostischen Bilddaten, insbesondere medizinischen und/oder diagnostischen Magnetresonanzbilddaten, eines Patienten ausgelegt und/oder ausgebildet ist. Die Magnetresonanzvorrichtung umfasst hierzu die Scannereinheit. Die Scannereinheit umfasst bevorzugt eine Magneteinheit zur Erfassung der medizinischen und/oder diagnostischen Bilddaten. Vorteilhafterweise umfasst hierbei die Scannereinheit, insbesondere die Magneteinheit, einen Grundmagneten, ein Gradientenspuleneinheit und eine Hochfrequenzantenneneinheit. Die Hochfrequenzantenneneinheit ist fest innerhalb der Scannereinheit angeordnet und zur Aussendung eines Anregungspulses ausgelegt und/oder ausgebildet.

Der Grundmagnet ist zur Erzeugung eines homogenen Grundmagnetfelds mit einer definierten Magnetfeldstärke, wie beispielsweise mit einer Magnetfeldstärke von 3 T oder 1,5 T usw., ausgebildet. Insbesondere ist der Grundmagnet zur Erzeugung eines starken und konstanten Grundmagnetfelds ausgebildet. Das homogene Grundmagnetfeld ist bevorzugt innerhalb des Patientenaufnahmebereichs der Magnetresonanzvorrichtung angeordnet und/oder vorzufinden. Die Gradientenspuleneinheit ist zu einer Erzeugung von Magnetfeldgradienten, die für eine Ortskodierung während einer Bildgebung verwendet werden, ausgebildet.

Der Patientenaufnahmebereich ist zu einer Aufnahme des Patienten, insbesondere des zu untersuchenden Bereichs des Patienten, für eine medizinische Magnetresonanzuntersuchung ausgelegt und/oder ausgebildet. Der Patientenaufnahmebereich umfasst bevorzugt den Bereich, der dem Patienten während einer Magnetresonanzuntersuchung zur Verfügung steht. Beispielsweise ist hierzu der Patientenaufnahmebereich zylinderförmig ausgebildet und/oder zylinderförmig von der Scannereinheit, insbesondere der Magneteinheit, der Magnetresonanzvorrichtung umgeben.

Innerhalb des Patientenaufnahmebereichs ist bevorzugt ein Field of View (FoV) und ein Isozentrum der Magnetresonanzvorrichtung angeordnet. Das FoV umfasst bevorzugt einen Erfassungsbereich der Magnetresonanzvorrichtung, innerhalb dessen die Bedingungen für eine Erfassung von medizinischen Bilddaten, insbesondere von Magnetresonanzbilddaten, innerhalb des Patientenaufnahmebereichs vorliegen, wie beispielsweise ein homogenes Grundmagnetfeld. Das Isozentrum der Magnetresonanzvorrichtung umfasst bevorzugt den Bereich und/oder Punkt innerhalb der Magnetresonanzvorrichtung, der die optimalen und/oder idealen Bedingungen für die Erfassung von medizinischen Bilddaten aufweist. Insbesondere umfasst das Isozentrum den homogensten Magnetfeldbereich innerhalb der Magnetresonanzvorrichtung.

Für eine Positionierung des Patienten, insbesondere des zu untersuchenden Bereichs des Patienten, innerhalb des Patientenaufnahmebereich weist die Magnetresonanzvorrichtung die Patientenlagerungsvorrichtung auf. Die Patientenlagerungsvorrichtung ist zu einer Lagerung des Patienten innerhalb des Patientenaufnahmebereichs ausgebildet. Die Patientenlagerungsvorrichtung weist hierzu einen bewegbaren Patiententisch auf, der insbesondere innerhalb des Patientenaufnahmebereichs der Magnetresonanzvorrichtung bewegbar ausgebildet ist. Bevorzugt ist hierbei der Patiententisch in Längsrichtung des Patientenaufnahmebereichs und/oder in z-Richtung innerhalb des Patientenaufnahmebereichs bewegbar ausgebildet. Für eine Magnetresonanzuntersuchung wird der Patient auf dem Patiententisch der Patientenlagerungsvorrichtung positioniert und für die Magnetresonanzuntersuchung erforderliche Zusatzeinheiten ebenfalls auf dem Patiententisch oder am Patienten positioniert. Anschließend erfolgt ein Positionieren des zu untersuchenden Bereichs bezüglich der Scannereinheit, insbesondere bezüglich des Isozentrums der Magneteinheit, mittels der Positionsbestimmungseinheit, insbesondere der Lasermarkiereinheit, und der Patiententisch fährt zusammen mit dem Patienten in den Patientenaufnahmebereich, bis der zu untersuchende Bereich des Patienten innerhalb des Isozentrums der Magnetresonanzvorrichtung angeordnet ist.

Die Positionsbestimmungseinheit ist zu einer Bestimmung der Position des Patiententischs bezüglich der Scannereinheit ausgebildet. Insbesondere ist die Positionsbestimmungseinheit zu einer Bestimmung einer Position des zu untersuchenden Bereiches bezüglich des Isozentrums der Scannereinheit ausgebildet. Hierzu weist die Positionsbestimmungseinheit die Lasermarkiereinheit auf. Die Lasermarkiereinheit ist über einer Eingangsöffnung des Patientenaufnahmebereiches in einem Gehäuse der Scannereinheit angeordnet und sendet zur Positionsbestimmung einen Laserstrahl, beispielsweise einen kreuzförmigen Laserstrahl, senkrecht nach unten. Mittels der Lasermarkiereinheit erfolgt eine Projektion einer Lasermarkierung, beispielsweise des kreuzförmigen Laserstrahls, auf dem zu untersuchenden Bereich des Patienten und/oder auf einer um den zu untersuchenden Bereich des Patienten angeordnete lokale Hochfrequenzspule. Dabei wird der Patiententisch von einem Benutzer so lange hin und her gefahren, bis die Laserprojektion mit dem zu untersuchenden Bereich des Patienten und/oder einer um den zu untersuchenden Bereich angeordneten lokalen Hochfrequenzspule übereinstimmt. Ein Abstand zwischen der Position der Laserprojektion auf dem Patiententisch und dem Isozentrum der Scannereinheit ist derart definiert, so dass nach einer Markierung des zu untersuchenden Bereichs mittels der Lasermarkiereinheit der Patiententisch in den Patientenaufnahmebereich einfährt, bis der zu untersuchende Bereich innerhalb des Isozentrums angeordnet ist.

Zudem weist die Positionsbestimmungseinheit eine Kalibriereinheit auf, wobei die Kalibriereinheit zu einer Kalibrierung der Lasermarkiereinheit ausgebildet ist. Insbesondere erfolgt mittels der Kalibriereinheit eine Kalibrierung einer Position der Lasermarkiereinheit, insbesondere eine Position der Lasermarkiereinheit bezüglich des Isozentrums der Scannereinheit. Vorzugsweise ist die Kalibriereinheit derart ausgebildet, dass ein Benutzer, insbesondere ein Magnetresonanzuntersuchungen durchführendes medizinisches Bedienpersonal, eine Kalibrierung der Lasermarkiereinheit durchführen kann.

Die Erfindung weist den Vorteil auf, dass eine einfache Erkennung und/oder Korrektur von Positionsfehlern der Lasermarkiereinheit möglich ist. Insbesondere kann ein Benutzer, beispielsweise ein medizinisches Bedienpersonal, Positionsfehler der Lasermarkiereinheit einfach mittels der Kalibriereinheit erkennen und korrigieren. Zudem kann auf eine zeitaufwendige und teure Wartung durch ein Servicepersonal zur Erkennung von Positionsfehlern der Lasermarkiereinheit vorteilhaft verzichtet werden. Beispielsweise kann eine Kalibrierungsmessung der Lasermarkiereinheit in definierten Zeitabständen, z.B. alle drei Monate, direkt von einem medizinischen Bedienpersonal durchgeführt werden. Zudem kann eine Kalibrierungsmessung der Lasermarkiereinheit auch bei und/oder vor definierten Workflowschritten, beispielsweise vor Messschritten zur Qualitätssicherung von lokalen Hochfrequenzspulen und/oder vor Justagemessungen, direkt von einem medizinischen Bedienpersonal durchgeführt werden.

In einer vorteilhaften Weiterbildung der Magnetresonanzvorrichtung kann es vorgesehen sein, dass die Kalibriereinheit zumindest ein Reflektorelement umfasst, das in einem Frontbereich des bewegbaren Patiententischs angeordnet ist. Das Reflektorelement ist dazu ausgebildet, den von der Lasermarkiereinheit in Richtung des Patiententischs gesendeten Laserstrahl zu reflektieren. Bevorzugt ist das Reflektorelement hierzu auf einer nach oben weisenden Oberfläche des Frontbereichs des Patiententischs angeordnet, so dass ein auf das Reflektorelement treffender Kalibrierungslaserstrahl im Wesentlichen um 180° reflektiert wird. Dabei kann das Reflektorelement auch derart ausgebildet sein, dass mit einem definierten Winkel, beispielsweise von 185°, der Kalibrierungsstrahl einer korrekt positionierten Lasermarkierungseinheit reflektiert wird. Bevorzugt ist das Reflektorelement an einer bestimmten und/oder definierten Position fest an dem Frontbereich des bewegbaren Patiententischs angeordnet, so dass für unterschiedliche Kalibrierungen das Reflektorelement stets an einer gleichen Position am Patiententisch angeordnet ist. Zudem kann derart ein gleicher Abstand zwischen dem Reflektorelement und dem Isozentrum der Magneteinheit erhalten werden. Derart ist das Reflektorelement vorteilhaft in einem Bereich des Patiententischs angeordnet, der für Kalibrierungsmessungen gut sichtbar ist und nicht von einem Messobjekt, beispielsweise einem Messphantom, abgedeckt wird.

Der Frontbereich des Patiententischs umfasst bevorzugt denjenigen Bereich des Patiententischs, der bei einem Einfahren des Patiententischs in den Patientenaufnahmebereich vorne am Patiententisch angeordnet ist. Mit anderen Worten umfasst der Frontbereich des Patiententischs denjenigen Bereich, der bei einem Einfahren des Patiententischs in den Patientenaufnahmebereich als erstes in den Patientenaufnahmebereich einfährt.

In einer vorteilhaften Weiterbildung der Magnetresonanzvorrichtung kann es vorgesehen sein, dass die Kalibriereinheit zumindest ein Sensorelement umfasst, das zu einer Erfassung eines Kalibrierungslaserstrahls ausgebildet ist. Der Kalibrierungslaserstrahl umfasst bevorzugt einen Laserstrahl, der zu Kalibrierung der Lasermarkiereinheit und/oder während einer Kalibrierungsmessung der Lasermarkiereinheit von dieser ausgesendet wird. Bevorzugt wird der Kalibrierungslaserstrahl vor einer Erfassung mittels des zumindest einen Sensorelements von dem Reflektorelement in Richtung des Sensorelements reflektiert. Diese Ausgestaltung der Erfindung ermöglicht eine einfache und direkte Erfassung des Kalibrierungslaserstrahls während einer Kalibrierungsmessung.

In einer vorteilhaften Weiterbildung der Magnetresonanzvorrichtung kann es vorgesehen sein, dass das zumindest eine Sensorelement eine Photodiode mit einer Schwellwertschaltung umfasst. Eine Schwellwertschaltung vergleicht eine von der Photodiode bereitgestellte Ausgangsgröße mit einem Schwellwert, wobei die von der Photodiode bereitgestellte Ausgangsgröße abhängig ist von einem erfassten Signal, beispielsweise dem erfassten Kalibrierungslaserstrahl. Die Ausgangsgröße der Photodiode kann beispielsweise eine Ausgangsspannung oder einen Ausgangsstrom umfassen. Ein Schaltvorgang innerhalb der Schwellwertschaltung wird ausgelöst, wenn die von der Photodiode gemessene Ausgangsgröße einen voreingestellten Schwellenwert überschreitet oder unterschreitet. Insbesondere variiert die Ausgangsgrößer der Photodiode, wenn der reflektierte Kalibrierungsstrahl aufgrund einer Positionsfehlers und/oder einer Positionsänderung der Lasermarkiereinheit nicht mehr genau auf die Photodiode trifft oder diese komplett verfehlt. Alternativ zu einer Photodiode kann die zumindest eine Sensoreinheit auch einen Phototransistor und/oder einen CMOS-Element und/oder weitere, dem Fachmann als sinnvoll erscheinende Ausgestaltungen des zumindest einen Sensorelements aufweisen. Hierdurch kann besonders direkt ein Positionsfehler der Lasermarkiereinheit während einer Kalibrierungsmessung erfasst und/oder erkannt werden.

In einer vorteilhaften Weiterbildung der Magnetresonanzvorrichtung kann es vorgesehen sein, dass die Kalibriereinheit eine Steuereinheit umfasst, wobei die Steuereinheit mit dem zumindest einen Sensorelement zu einem Datenaustausch verbunden ist, wobei die Steuereinheit dazu ausgebildet ist, abhängig von einem Ausgangsignal der Schwellwertschaltung eines Ausgabeinformation an den Benutzer zu generieren. Bevorzugt ist die Steuereinheit dazu ausgebildet, bei einer erkannten Fehlpositionierung und/oder Positionsänderung der Lasermarkiereinheit während einer Kalibrierungsmessung eine Ausgabeinformation an den Benutzer zu generieren. Zudem ist die Steuereinheit dazu ausgebildet, die Ausgabeinformation einer Ausgabeeinheit für eine Ausgabe an den Benutzer bereitzustellen. Die Ausgabeinformation wird bevorzugt mittels einer Ausgabeeinheit, beispielsweise einem Display, der Magnetresonanzvorrichtung an den Benutzer ausgegeben. Zudem kann die Steuereinheit auch bei einer korrekten Position der Lasermarkiereinheit während einer Kalibrierungsmessung eine Ausgabeinformation für einen Benutzer generieren und bereitstellen. Bevorzugt informiert die Ausgabeinformation den Benutzer über die Position, bevorzugt eine aktuelle Position, der Lasermarkiereinheit während einer Kalibrierungsmessung, beispielsweise ob die Lasermarkiereinheit eine korrekte Position einnimmt oder eine Fehlpositionierung der Lasermarkiereinheit vorliegt. Die Ausgabeinformation an den Benutzer ermöglicht es dem Benutzer auch, eine Korrektur, insbesondere eine Positionskorrektur, der Lasermarkiereinheit vorzunehmen. Insbesondere kann hierbei auch der Benutzer bei einer Positionskorrektur der Lasermarkeireinheit stets über eine aktuelle Position der Lasermarkiereinheit, insbesondere ob diese korrekt oder ob weiterhin eine Fehlpositionierung der Lasermarkiereinheit vorliegt, informiert werden.

Die Steuereinheit umfasst zumindest ein Rechenmodul und/oder einen Prozessor. So ist insbesondere die Steuereinheit dazu ausgebildet, computerlesbare Instruktionen auszuführen. Insbesondere umfasst die Steuereinheit eine Speichereinheit, wobei auf der Speichereinheit computerlesbare Informationen gespeichert sind, wobei die Steuereinheit dazu ausgebildet ist, die computerlesbaren Informationen von der Speichereinheit zu laden und die computerlesbaren Informationen auszuführen. Derart ist die Steuereinheit dazu ausgebildet, abhängig von einem Ausgangsignal der Schwellwertschaltung eines Ausgabeinformation an den Benutzer zu generieren und bereitzustellen.

Die Komponenten der Steuereinheit können zum überwiegenden Teil in Form von Softwarekomponenten ausgebildet sein. Grundsätzlich können diese Komponenten aber auch zum Teil, insbesondere wenn es um besonders schnelle Berechnungen geht, in Form von softwareunterstützten Hardwarekomponenten, beispielsweise FPGAs oder dergleichen, realisiert sein. Ebenso können die benötigten Schnittstellen, beispielsweise wenn es nur um eine Übernahme von Daten aus anderen Softwarekomponenten geht, als Softwareschnittstellen ausgebildet sein. Sie können aber auch als hardwaremäßig aufgebaute Schnittstellen ausgebildet sein, die durch geeignete Software angesteuert werden. Selbstverständlich ist es auch denkbar, dass mehrere der genannten Komponenten in Form einer einzelnen Softwarekomponente bzw. softwareunterstützter Hardwarekomponente zusammengefasst realisiert sind.

Die Steuereinheit der Kalibriereinheit kann dabei von einer Systemsteuereinheit der Magnetresonanzvorrichtung umfasst sein und in diese integriert sein. Alternativ hierzu kann die Steuereinheit der Kalibriereinheit auch separat zur Systemsteuereinheit der Magnetresonanzvorrichtung ausgebildet sein.

In einer vorteilhaften Weiterbildung der Magnetresonanzvorrichtung kann es vorgesehen sein, dass das zumindest eine Sensorelement an der Lasermarkiereinheit angeordnet ist. Dabei kann das zumindest eine Sensorelement an die Lasermarkiereinheit angrenzend, insbesondere direkt neben der Lasermarkiereinheit, angeordnet sein. Bevorzugt ist das zumindest eine Sensorelement derart an der Lasermarkiereinheit angeordnet, dass bei einer Positionskorrektur der Lasermarkiereinheit das zumindest eine Sensorelement zusammen mit der Lasermarkiereinheit eine Positionsänderung erfährt. Durch die Anordnung des zumindest einen Sensorelements an der Lasermarkiereinheit kann eine einfache und direkte Erfassung des Kalibrierungslaserstrahls, insbesondere des von dem Reflektorelement reflektierten Kalibrierungslaserstrahls, während einer Kalibrierungsmessung vorteilhaft erreicht werden. Ein weiterer Vorteil ist, dass das Reflektorelement zur Reflexion des Kalibrierungslaserstrahls einfach und zeitsparend auf eine waagrechte Oberfläche des Patiententischs angebracht werden kann. Eine aufwendige Einstellung des Reflektorelements zur Einstellung eines definierten Reflexionswinkels, bevorzugt von 180° abweichenden Reflexionswinkels, kann hierdurch vorteilhaft entfallen.

In einer vorteilhaften Weiterbildung der Magnetresonanzvorrichtung kann es vorgesehen sein, dass die Scannereinheit eine Gehäuseeinheit umfasst, wobei die Gehäuseeinheit ein Gehäuseelement mit einem Aufnahmebereich zur Aufnahme der Lasermarkiereinheit umfasst, wobei die Lasermarkiereinheit zusammen mit dem zumindest einem Sensorelement der Kalibriereinheit in dem Aufnahmebereich des Gehäuseelements angeordnet ist. Bevorzugt ist das Gehäuseelement mit dem Aufnahmebereich zur Aufnahme der Lasermarkiereinheit in einem Übergangsbereich zwischen dem Patientenaufnahmebereich und einer Frontseite der Scannereinheit angeordnet. Besonders vorteilhaft ist dabei das Gehäuseelement um eine Einführöffnung des Patientenaufnahmebereichs angeordnet und umfasst beispielsweise ein trichterförmiges Gehäuseelement. Die Gehäuseeinheit weist neben dem Gehäuseelement, das um die Einführöffnung des Patientenaufnahmebereichs angeordnet ist, zudem weitere Einheiten, wie beispielsweise eine Frontverkleidungseinheit, eine Heckverkleidungseinheit und eine Seitenverkleidungseinheit auf, die zu einer Verkleidung einer Frontseite, einer Heckseite und von Seitenbereichen der Scannereinheit, insbesondere der Magneteinheit, ausgebildet sind. Die Einführöffnung des Patientenaufnahmebereichs umfasst eine frontseitige Öffnung des Patientenaufnahmebereichs, durch die der Patiententisch in den Patientenaufnahmebereich eingefahren wird. Zudem kann der Patientenaufnahmebereich auch eine heckseitige Öffnung umfassen. Der Aufnahmebereich zur Aufnahme der Lasermarkiereinheit ist hierbei in das Gehäuseelement integriert und bevorzugt nach unten offen ausgebildet, so dass der Laserstrahl zur Markierung eines zu untersuchenden Bereichs nach unten in Richtung des Patiententischs, insbesondere senkrecht nach unten, den Aufnahmebereich verlassen kann. Hierdurch kann eine geschützte Anordnung sowohl der Lasermarkiereinheit als auch des Sensorelements der Kalibriereinheit erreicht werden.

In einer vorteilhaften Weiterbildung der Magnetresonanzvorrichtung kann es vorgesehen sein, dass die Kalibriereinheit zumindest ein Einstellelement umfasst, das zu einer Einstellung einer Position der Lasermarkiereinheit in zumindest eine Richtung ausgebildet ist. Die zumindest eine Richtung, in der die Position der Lasermarkiereinheit mittels des Einstellelements eingestellt werden kann, umfasst bevorzugt eine Richtung parallel zu einer z-Richtung der Scannereinheit. Die z-Richtung der Scannereinheit ist dabei parallel zu einer Längsrichtung des Patientenaufnahmebereichs und/oder einer Einfahrrichtung des Patiententischs in den Patientenaufnahmebereich hinein. Das Einstellelement ist bevorzugt zu einer manuellen Einstellung und/oder Korrektur der Position der Lasermarkiereinheit durch einen Benutzer, insbesondere ein medizinisches Bedienpersonals, ausgebildet. Insbesondere kann während einer Kalibrierungsmessung der Benutzer mittels des Einstellelements die Position der Lasermarkiereinheit in die zumindest eine Richtung korrigieren, sofern eine Fehlpositionierung der Lasermarkiereinheit vorliegt. Dies ermöglicht eine einfache und direkte Korrektur einer Fehlpositionierung der Lasermarkiereinheit durch den Benutzer.

In einer vorteilhaften Weiterbildung der Magnetresonanzvorrichtung kann es vorgesehen sein, dass das zumindest eine Einstellelement ein Stellrad zum Einstellen der Position der Lasermarkiereinheit in die zumindest eine Richtung aufweist. Das Stellrad kann beispielsweise eine Verzahnung aufweisen, beispielsweise an einer Außenseite des Stellrads. Beispielseise kann die Verzahnung des Stellrads in eine Verzahnung einer Zahnstange greifen, so dass durch Drehen des Stellrads eine axiale Bewegung der Zahnstange erfolgen kann. Dabei kann die Lasermarkiereinheit auf der Zahnstange des Einstellelements angeordnet und/oder gelagert sein, so dass durch Drehen des Stellrads eine axiale Bewegung der Zahnstange und damit der Lasermarkiereinheit erfolgen kann. Zudem kann das Stellrad auch mit einer Welle verbunden sein, wobei die Welle in eine Verzahnung zur axialen Bewegung der Lasermarkiereinheit greift. Zudem sind weitere Ausbildungen, insbesondere von einem Stellrad abweichende Ausbildungen, des Einstellelements in einer alternativen Ausgestaltung des Einstellelements denkbar. Mittels des Stellrads kann eine einfache und direkte Einstellung und/oder Korrektur der Position der Lasermarkiereinheit manuell durch einen Benutzer erfolgen. Zudem kann derart auch eine besonders feine und/oder genaue Einstellung in kleinen Schritten bereitgestellt werden.

In einer vorteilhaften Weiterbildung der Magnetresonanzvorrichtung kann es vorgesehen sein, dass das zumindest eine Einstellelement zu einer Einstellung der Position der Lasermarkiereinheit in die zumindest eine Richtung um maximal ±1 mm ausgebildet ist. Bevorzugt ist das Einstellelement zu einer Einstellung und/oder Korrektur der Position der Lasermarkiereinheit in die zumindest eine Richtung um maximal ±2 mm ausgebildet. Bevorzugt ist das Einstellelement zu einer Einstellung und/oder Korrektur der Position der Lasermarkiereinheit in die zumindest eine Richtung um maximal ±3 mm ausgebildet. Bevorzugt ist das Einstellelement zu einer Einstellung und/oder Korrektur der Position der Lasermarkiereinheit in die zumindest eine Richtung um maximal ±4 mm ausgebildet. Bevorzugt ist das Einstellelement zu einer Einstellung und/oder Korrektur der Position der Lasermarkiereinheit in die zumindest eine Richtung um maximal ±5 mm ausgebildet. Besonders vorteilhaft ist das Einstellelement zu einer Einstellung und/oder Korrektur der Position der Lasermarkiereinheit in die zumindest eine Richtung um bis zu ±6 mm ausgebildet. Derart kann für kleine Korrekturen und/oder kleine Positionsfehler der Lasermarkiereinheit eine einfache und kostengünstige Korrektur direkt durch einen Benutzer bereitgestellt werden.

In einer vorteilhaften Weiterbildung der Magnetresonanzvorrichtung kann es vorgesehen sein, dass das zumindest eine Einstellelement an der Lasermarkiereinheit angeordnet ist. Dabei kann das Einstellelement zumindest teilweise auch zusammen mit der Lasermarkiereinheit in dem Aufnahmebereich des Gehäuseelements angeordnet sein, wobei das Einstellelement, insbesondere das Stellrad des Einstellelements, von außen bedienbar ist. Derart kann eine robuste Einstellung und/oder Korrektur einer Position der Lasermarkiereinheit für einen Benutzer bereitgestellt werden, da auf lange Übertragungswege und/oder Übertragungselemente, beispielsweise eine Antriebswelle, vorteilhaft verzichtet werden.

Mittels der Kalibriereinheit kann eine Positionskorrektur der Lasermarkiereinheit in einem Bereich von bis zu ±6 mm ausgeglichen werden. Insbesondere kann hierbei die Positionskorrektur der Lasermarkiereinheit direkt von einem Benutzer, insbesondere einem medizinischen Bedienpersonal, durchgeführt werden. Damit kann ein Einsatz eines Servicetechnikers vorteilhaft eingespart werden. Sind größere Positionsfehler und/oder Abweichungen von der Sollposition des Lasermarkiereinheit vorhanden, insbesondere Abweichungen von größer ±6 mm, ist jedoch ein Einsatz eines Servicetechnikers sinnvoll. Derartig große Abweichungen werden zumeist durch einen Winkelfehler in der Aufhängung der Lasermarkiereinheit hervorgerufen. Um derartige große Abweichungen zu beheben, könnte die Kalibriervorrichtung beispielsweise mit einer kardianischen Aufhängung und/oder einem zweiten Stellrad zur Korrektur eines Anstellwinkels der Lasermarkiereinheit versehen werden, so dass weiterhin eine Korrektur der Position der Lasermarkiereinheit direkt von einem Benutzer durchgeführt werden kann.

Weitere Vorteile, Merkmale und Einzelheiten der Erfindung ergeben sich aus dem im Folgenden beschriebenen Ausführungsbeispiel sowie anhand der Zeichnungen.

Es zeigen:
- Fig. 1: eine erfindungsgemäße Magnetresonanzvorrichtung mit einer Positionsbestimmungseinheit in einer schematischen Darstellung, und
- Fig. 2: eine schematische Darstellung der Positionsbestimmungseinheit mit einer Lasermarkiereinheit und einer Kalibriereinheit in einer schematischen Darstellung.

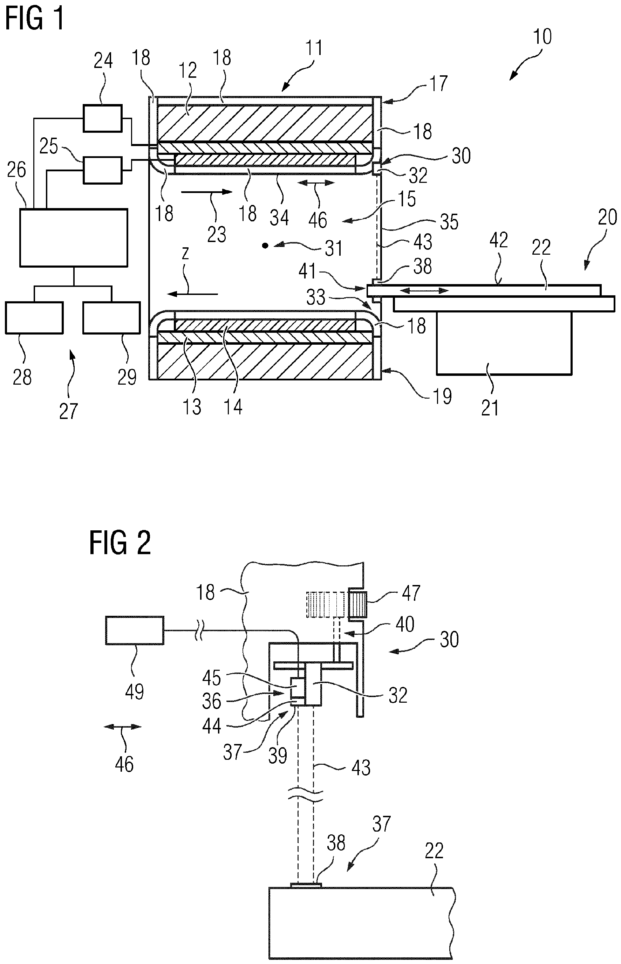

In der Fig. 1 ist eine Magnetresonanzvorrichtung 10 schematisch dargestellt. Die Magnetresonanzvorrichtung 10 umfasst eine von einer Magneteinheit 11 gebildeten Scannereinheit mit einem Grundmagneten 12, einer Gradientenspuleneinheit 13 und einer Hochfrequenzantenneneinheit 14. Zudem weist die Magnetresonanzvorrichtung 10 einen Patientenaufnahmebereich 15 auf zu einer Aufnahme eines Patienten für eine Magnetresonanzuntersuchung. Der Patientenaufnahmebereich 15 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 15 jederzeit denkbar. Die Scannereinheit der Magnetresonanzvorrichtung 10 weist des Weiteren eine Gehäuseeinheit 17 auf, die zu einer Verkleidung der Scannereinheit ausgebildet sind. Die Gehäuseeinheit 17 weist hierzu mehrere Gehäuseelemente 18, insbesondere Frontverkleidungselemente zur Verkleidung einer Frontseite 19 der Magneteinheit 11, Heckverkleidungselemente zur Verkleidung einer Heckseite der Magneteinheit 11, Seitenverkleidungselemente zur Verkleidung der Seitenflächen der Magneteinheit 11 und eine den Patientenaufnahmebereich 15 umgebende Umhausung 34, auf.

Für eine Positionierung des Patienten, insbesondere eines zu untersuchenden Bereichs des Patienten, innerhalb des Patientenaufnahmebereichs 15 weist die Magnetresonanzvorrichtung 10 eine Patientenlagerungsvorrichtung 20 auf. Die Patientenlagerungsvorrichtung 20 weist eine Basiseinheit 21 und einen bezüglich der Basiseinheit 21 bewegbaren Patiententisch 22 auf. Der Patiententisch 22 ist für eine Positionierung des Patienten, insbesondere des zu untersuchenden Bereichs des Patienten, bewegbar innerhalb des Patientenaufnahmebereichs 15 ausgebildet. Insbesondere ist hierbei der Patiententisch 22 in Richtung einer Längserstreckung des Patientenaufnahmebereichs 15 und/oder in z-Richtung der Magneteinheit 11 bewegbar gelagert.

Der Grundmagnet 12 der Magneteinheit 11 ist zu einem Erzeugen eines starken und insbesondere konstanten Grundmagnetfelds 23 ausgebildet. Dabei kann der Grundmagnet 12 beispielsweise als supraleitender Grundmagnet 12 oder auch als Dauermagnet ausgebildet sein. Die Gradientenspuleneinheit 13 der Magneteinheit 11 ist zu einer Erzeugung von Magnetfeldgradienten, die für eine Ortskodierung während einer Bildgebung verwendet werden, ausgebildet. Die Gradientenspuleneinheit 13 wird mittels einer Gradientensteuereinheit 24 der Magnetresonanzvorrichtung 10 gesteuert. Die Hochfrequenzantenneneinheit 14 der Magneteinheit 11 ist zu einer Anregung einer Polarisation, die sich in dem von dem Grundmagneten 12 erzeugten Grundmagnetfeld 23 einstellt, ausgebildet. Die Hochfrequenzantenneneinheit 14 wird von einer Hochfrequenzantennensteuereinheit 25 der Magnetresonanzvorrichtung 10 gesteuert und strahlt hochfrequente Magnetresonanzsequenzen in den Patientenaufnahmebereich 15 der Magnetresonanzvorrichtung 10 ein.

Zu einer Steuerung des Grundmagneten 12, der Gradientensteuereinheit 24 und zur Steuerung der Hochfrequenzantennensteuereinheit 25 weist die Magnetresonanzvorrichtung 10 eine Systemsteuereinheit 26 auf. Die Systemsteuereinheit 26 steuert zentral die Magnetresonanzvorrichtung 10, wie beispielsweise das Durchführen einer vorbestimmten bildgebenden Gradientenechosequenz. Zudem umfasst die Systemsteuereinheit 26 eine nicht näher dargestellte Auswerteeinheit zu einer Auswertung von medizinischen Bilddaten, die während der Magnetresonanzuntersuchung erfasst werden.

Des Weiteren umfasst die Magnetresonanzvorrichtung 10 eine Benutzerschnittstelle 27, die mit der Systemsteuereinheit 26 verbunden ist. Steuerinformationen wie beispielsweise Bildgebungsparameter, sowie rekonstruierte Magnetresonanzbilder können auf einer Darstellungseinheit 28 und/oder Ausgabeeinheit, beispielsweise auf zumindest einem Monitor, der Benutzerschnittstelle 27 für ein medizinisches Bedienpersonal angezeigt werden. Weiterhin weist die Benutzerschnittstelle 27 eine Eingabeeinheit 29 auf, mittels der Informationen und/oder Parameter während eines Messvorgangs von einem medizinischen Bedienpersonal eingegeben werden können.

Die Magnetresonanzvorrichtung 10 weist des Weiteren eine Positionsbestimmungseinheit 30 (Fig. 1 und 2) auf, die zu einer Bestimmung einer Position des Patiententischs 22 bezüglich der Scannereinheit, insbesondere der Magneteinheit 11, ausgebildet ist. Dabei ist die Positionsbestimmungseinheit 30 zur Bestimmung einer Position des Patiententischs 22, insbesondere der Position eines zu untersuchenden Bereichs des Patienten, bezüglich eines Isozentrums 31 der Magneteinheit 11 ausgebildet. Die Positionsbestimmungseinheit 30 weist hierzu eine Lasermarkiereinheit 32 auf. Die Lasermarkiereinheit 32 ist hierbei in einem Gehäuseelement 18 der Gehäuseeinheit 17 angeordnet. Das Gehäuseelement 18 umfasst dabei ein trichterförmiges Gehäuseelement 18, insbesondere einen Einsatztrichter, und ist in einem Übergangsbereich 33 zwischen der den Patientenaufnahmebereich 15 umgebenden Umhausung 34 und der Frontseite 19 angeordnet. Das trichterförmige Gehäuseelement 18 umgibt dabei eine Einführöffnung 35 des Patientenaufnahmebereichs 15. Das trichterförmige Gehäuseelement 18 weist einen Aufnahmebereich 36 zur Aufnahme der Lasermarkiereinheit 32 auf. Dieser Aufnahmebereich 36 ist über der Einführöffnung 35 des Patientenaufnahmebereichs 15 angeordnet, wobei der Aufnahmebereich 36 nach unten offen ausgebildet ist.

Des Weiteren weist die Positionsbestimmungseinheit 30 eine Kalibriereinheit 37 auf, die zu einer Kalibrierung der Lasermarkiereinheit 32 ausgebildet ist. Insbesondere ist die Kalibriereinheit 37 zu einer Positionskalibrierung der Lasermarkiereinheit 32 ausgebildet. Hierzu weist die Kalibriereinheit 37 ein Reflektorelement 38, ein Sensorelement 39 und ein Einstellelement 40 auf (Fig. 2).

Das Reflektorelement 38 der Kalibriereinheit 37 ist auf dem bewegbaren Patiententisch 22 angeordnet. Insbesondere ist das Reflektorelement 38 in einem Frontbereich 41 des bewegbaren Patiententischs 22 angeordnet. Dabei ist das Reflektorelement 38 auf einer nach oben weisenden Oberfläche 42 des Frontbereichs 41 des Patiententischs 22 angeordnet. Das Reflektorelement 38 ist zu einer Reflexion eines von der Lasermarkiereinheit 32 ausgesendeten Kalibrierungslaserstrahls 43 während einer Kalibrierungsmessung ausgebildet. Der Kalibrierungslaserstrahl 43 umfasst dabei einen von der Lasermarkiereinheit 32 ausgesendeten Laserstrahl, der zu einer Kalibrierung der Lasermarkiereinheit 32 ausgesendet wird. Während einer Kalibrierungsmessung befindet sich der Patiententisch 22 in einer definierten Startposition bezüglich des Isozentrums 31 der Scannereinheit. In dieser Startposition des Patiententischs 22 befindet sich das Reflektorelement 38 senkrecht unterhalb der Lasermarkiereinheit 32, wenn diese korrekt positioniert ist. Ein von der Lasermarkiereinheit 32 ausgesandter Kalibrierungslaserstrahl 43, der senkrecht nach unten von der Lasermarkiereinheit 32 ausgesendet wird, trifft somit auf das Reflektorelement 38 und wird von diesem reflektiert.

Das Sensorelement 39 der Kalibrierungseinheit 30 ist zu einer Erfassung des Kalibrierungslaserstrahls 43 ausgebildet. Insbesondere ist das Sensorelement 39 zu einer Erfassung des von dem Reflektorelement 38 reflektierten Kalibrierungslaserstrahl 43 ausgebildet. Das Sensorelement 39 ist dabei an der Lasermarkiereinheit 32 angeordnet. Insbesondere ist das Sensorelement 39 zusammen mit der Lasermarkiereinheit 32 innerhalb des Aufnahmebereichs 36 zur Aufnahme der Lasermarkiereinheit 32 an dem Gehäuseelement 18 angeordnet.

Das Sensorelement 39 umfasst eine Photodiode 44 mit einer Schwellwertschaltung 45. Die Schwellwertschaltung 45 vergleicht dabei eine von der Photodiode 44 bereitgestellte Ausgangsgröße mit einem Schwellwert, wobei die von der Photodiode 44 bereitgestellte Ausgangsgröße abhängig ist von einer Intensität des erfassten Kalibrierungslaserstrahl 43. Die Ausgangsgröße der Photodiode 44 kann beispielsweise eine Ausgangsspannung oder einen Ausgangsstrom umfassen. Insbesondere variiert die Ausgangsgrößer der Photodiode 44, wenn der reflektierte Kalibrierungsstrahl 43 aufgrund einer Positionsfehlers und/oder einer Positionsänderung der Lasermarkiereinheit 32 nicht mehr genau auf die Photodiode 44 trifft oder diese komplett verfehlt. Ein Schaltvorgang innerhalb der Schwellwertschaltung 45 wird ausgelöst, wenn die von der Photodiode 44 gemessene Ausgangsgröße einen voreingestellten Schwellenwert überschreitet oder unterschreitet.

Das Einstellelement 40 der Kalibriereinheit 30 ist zu einer Einstellung einer Position der Lasermarkiereinheit 32 in eine Richtung 46 ausgebildet. Die Richtung 46, in der die Position der Lasermarkiereinheit 32 mittels des Einstellelements 40 einstellbar ist, umfasst bevorzugt die z-Richtung der Scannereinheit, insbesondere der Magneteinheit 11. Das Einstellelement 40 umfasst im vorliegenden Ausführungsbeispiel ein Stellrad 47, wobei durch Drehen des Stellrads 47 durch einen Benutzer eine Positionierung der Lasermarkiereinheit 32 in z-Richtung erfolgt. Dabei kann das Stellrad 47 eine Verzahnung, beispielsweise an einer Außenseite des Stellrads 47, aufweisen, die in eine Zahnstange des Einstellelements 40 greift, an der die Lasermarkiereinheit 32 angeordnet ist, so dass durch Drehen des Stellrads 47 eine axiale Bewegung der Lasermarkiereinheit 32 bewirkt wird. Zudem kann das Stellrad 47 auch mit einer Welle verbunden sein, die in eine Verzahnung zur axialen Bewegung der Lasermarkiereinheit 32 greift. Zudem sind weitere Ausgestaltungen des Einstellelements 40 jederzeit möglich. Insbesondere wird bei einer Positionierung der Lasermarkiereinheit 32 in die Richtung 36 auch das Sensorelement 39, das an der Lasermarkiereinheit 32 angeordnet ist, mitbewegt.

Das Einstellelement 40 ist dabei zu einer Einstellung der Position der Lasermarkiereinheit 32 und/oder zu einer Positionskorrektur der Lasermarkiereinheit 32 in die z-Richtung um maximal ±1 mm ausgebildet. Bevorzugt ist das Einstellelement 40 zu einer Einstellung der Position der Lasermarkiereinheit 32 und/oder zu einer Positionskorrektur der Lasermarkiereinheit 32 in die z-Richtung um maximal ±2 mm ausgebildet. Bevorzugt ist das Einstellelement 40 zu einer Einstellung der Position der Lasermarkiereinheit 32 und/oder zu einer Positionskorrektur der Lasermarkiereinheit 32 in die z-Richtung um maximal ±3 mm ausgebildet. Bevorzugt ist das Einstellelement 40 zu einer Einstellung der Position der Lasermarkiereinheit 32 und/oder zu einer Positionskorrektur der Lasermarkiereinheit 32 in die z-Richtung um maximal ±4 mm ausgebildet. Bevorzugt ist das Einstellelement 40 zu einer Einstellung der Position der Lasermarkiereinheit 32 und/oder zu einer Positionskorrektur der Lasermarkiereinheit 32 in die z-Richtung um maximal ±5 mm ausgebildet. Bevorzugt ist das Einstellelement 40 zu einer Einstellung der Position der Lasermarkiereinheit 32 und/oder zu einer Positionskorrektur der Lasermarkiereinheit 32 in die z-Richtung um maximal ±6 mm ausgebildet.

Das Einstellelement 40 ist zudem an der Lasermarkiereinheit 32 angeordnet. Insbesondere ist das Einstellelement 40 innerhalb des Aufnahmebereichs 36 zur Aufnahme der Lasermarkiereinheit 32 zusammen mit der Lasermarkiereinheit 32 an dem Gehäuseelement 18 angeordnet, wobei das Einstellelement 40 von außen von einem Benutzer bedienbar ist.

In einer alternativen Ausgestaltung kann das Einstellelement 40 auch eine von einem Stellrad 47 abweichende Ausgestaltung aufweisen.

Zudem umfasst die Kalibriereinheit 30 eine Steuereinheit 49, wobei die Steuereinheit 49 mit dem Sensorelement 39 zu einem Datenaustausch verbunden ist. Die Steuereinheit 49 ist dazu ausgebildet ist, abhängig von dem Ausgangssignal der Schwellwertschaltung 45 eine Ausgabeinformation an den Benutzer zu generieren und diese für eine Ausgabe bereitzustellen. Die Ausgabeinformation wird bevorzugt mittels der Darstellungseinheit 28 und/der Ausgabeeinheit der Benutzerschnittstelle 27 der Magnetresonanzvorrichtung 10 an den Benutzer ausgegeben. Bevorzugt ist die Steuereinheit 49 dazu ausgebildet, bei einer erkannten Fehlpositionierung und/oder Positionsänderung der Lasermarkiereinheit 32 während einer Kalibrierungsmessung eine Ausgabeinformation an den Benutzer zu generieren. Zudem kann die Steuereinheit 50 auch bei einer korrekten Position der Lasermarkiereinheit 32 während einer Kalibrierungsmessung eine Ausgabeinformation für einen Benutzer generieren und bereitstellen. Bevorzugt informiert die Ausgabeinformation den Benutzer über die Position, bevorzugt eine aktuelle Position, der Lasermarkiereinheit 32 während einer Kalibrierungsmessung.

Die dargestellte Magnetresonanzvorrichtung 10 kann selbstverständlich weitere Komponenten umfassen, die Magnetresonanzvorrichtungen 10 gewöhnlich aufweisen. Eine allgemeine Funktionsweise einer Magnetresonanzvorrichtung 10 ist zudem dem Fachmann bekannt, so dass auf eine detaillierte Beschreibung der weiteren Komponenten verzichtet wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Magnetresonanzvorrichtung mit einer Scannereinheit, einen von der Scannereinheit zumindest teilweise umgebenen Patientenaufnahmebereich, einer Patientenlagerungsvorrichtung, die einen bewegbaren Patiententisch, der zu einem Einfahren in den Patientenaufnahmebereich ausgebildet ist, aufweist, und einer Positionsbestimmungseinheit, die zu einer Bestimmung einer Position des Patiententischs bezüglich der Scannereinheit ausgebildet ist und die eine Lasermarkiereinheit umfasst, **dadurch gekennzeichnet, dass** die Positionsbestimmungseinheit eine Kalibriereinheit zu einer Kalibrierung der Lasermarkiereinheit umfasst.

2. Magnetresonanzvorrichtung nach Anspruch 1,
**dadurch gekennzeichnet, dass** die Kalibriereinheit zumindest ein Reflektorelement umfasst, das in einem Frontbereich des bewegbaren Patiententischs angeordnet ist.

3. Magnetresonanzvorrichtung nach einem der vorhergehenden Ansprüche,
**dadurch gekennzeichnet, dass** die Kalibriereinheit zumindest ein Sensorelement umfasst, das zu einer Erfassung eines Kalibrierungslaserstrahls ausgebildet ist.

4. Magnetresonanzvorrichtung nach Anspruch 3,
**dadurch gekennzeichnet, dass** das zumindest eine Sensorelement eine Photodiode mit einer Schwellwertschaltung umfasst.

5. Magnetresonanzvorrichtung nach einem der Ansprüche 3 bis 4,
**dadurch gekennzeichnet, dass** die Kalibriereinheit eine Steuereinheit umfasst, wobei die Steuereinheit mit dem zumindest einen Sensorelement zu einem Datenaustausch verbunden ist, wobei die Steuereinheit dazu ausgebildet ist, abhängig von einem Ausgangssignal der Schwellwertschaltung eine Ausgabeinformation an den Benutzer zu generieren.

6. Magnetresonanzvorrichtung nach einem der Ansprüche 3 bis 5,
**dadurch gekennzeichnet, dass** das zumindest eine Sensorelement an der Lasermarkiereinheit angeordnet ist.

7. Magnetresonanzvorrichtung nach einem der Ansprüche 3 bis 6,
**dadurch gekennzeichnet, dass** die Scannereinheit eine Gehäuseeinheit umfasst, wobei die Gehäuseeinheit ein Gehäuseelement mit einen Aufnahmebereich zur Aufnahme der Lasermarkiereinheit umfasst, wobei die Lasermarkiereinheit zusammen mit dem zumindest einem Sensorelement der Kalibriereinheit in dem Aufnahmebereich des Gehäuseelements angeordnet ist.

8. Magnetresonanzvorrichtung nach einem der vorhergehenden Ansprüche,
**dadurch gekennzeichnet, dass** die Kalibriereinheit zumindest ein Einstellelement umfasst, das zu einer Einstellung einer Position der Lasermarkiereinheit in zumindest eine Richtung ausgebildet ist.

9. Magnetresonanzvorrichtung nach Anspruch 8,
**dadurch gekennzeichnet, dass** das zumindest eine Einstellelement ein Stellrad zum Einstellen der Position der Lasermarkiereinheit in die zumindest eine Richtung aufweist.

10. Magnetresonanzvorrichtung nach einem der Ansprüche 8 bis 9,
**dadurch gekennzeichnet, dass** das zumindest eine Einstellelement zu einer Einstellung der Position der Lasermarkiereinheit in die zumindest eine Richtung um maximal ±1 mm ausgebildet ist.

11. Magnetresonanzvorrichtung nach einem der Ansprüche 8 bis 10,
**dadurch gekennzeichnet, dass** das zumindest eine Einstellelement an der Lasermarkiereinheit angeordnet ist.
